# EUROPEAN PATENT SPECIFICATION

(11) **EP 2 747 122 B1**
(45) Date of publication and mention of the grant of the patent: **03.07.2019**
(21) Application number: 12198692.1
(22) Date of filing: 20.12.2012
(51) Int. Cl.: H01J 37/32, H01M 4/04, H01M 10/04

(54) **Plasma enhanced deposition arrangement for evaporation of dielectric materials, deposition apparatus and methods of operating thereof**
Plasmaverstärkte Ablagerungsanordnung zur Verdampfung von dielektrischen Materialien, Ablagerungsvorrichtung und Verfahren zum Betrieb davon
Agencement de dépôt amélioré de plasma pour l'évaporation de matériaux diélectriques, appareil de dépôt et procédés de fonctionnement associés

(43) Date of publication of application: 25.06.2014
(73) Proprietor: Applied Materials, Inc., Santa Clara, CA 95054 (US)
(72) Inventor: Keller, Stefan, 63814 Mainaschaff (DE); Bangert, Stefan, 36396 Steinau (DE); Kwak, Byung-Sung Leo, Portland, OR Oregon 97229 (US)
(74) Representative: Zimmermann & Partner Patentanwälte mbB

(56) References cited:
- EP-A1- 2 128 303
- WO-A1-2009/023744
- US-A1- 2005 011 443
- US-A1- 2010 267 191
- US-A1- 2012 312 474

## Description

### TECHNICAL FIELD OF THE INVENTION

Embodiments of the present invention relate to evaporation and deposition of dielectric materials of multiple elements, such Lithium Cobalt Oxide (LiCoO₂, LCO), or Lithium Orthophosphate (Li₃PO₄) for deposition of Lithium Phosphorous Oxynitride (LiPON). Embodiments of the present invention particularly relate to evaporation arrangements, deposition apparatuses, and methods of operation thereof. Specifically, they relate to a depositing arrangement for evaporation of a material comprising a multiple element dielectric material and for deposition of the material on a substrate, a deposition apparatus for evaporation of a material comprising a multiple element dielectric material and for deposition of the material on a substrate, and a method of evaporating a material comprising a multiple element dielectric material, particularly LCO, Li₃PO₄ or LiPON.

### BACKGROUND OF THE INVENTION

Modern thin film lithium batteries are, as a rule, produced in a vacuum chamber, wherein a substrate is provided with several layers, for example including lithium containing dielectrics. The lithium containing dielectric layer is formed, for example, through the deposition of vapor of the respective material on the substrate. Since lithium is highly reactive, and also compounds containing lithium can be reactive, a plurality of measures needs to be addressed to operate and maintain such deposition systems. For example, exposure to air ambient's oxidizing vapors, in particular H₂O, and contact with personnel after opening the vacuum chamber should be minimized. For example, the following list of documents describe various arrangements for coating a substrate: WO 2009/023744 A1, US 2010/267191 A1, EP 2 128 303 A1, US 2012/312474 A1, and US 2005/011443 A1.

Further, vaporization with high deposition rates and increased uniformity is a desire. Many types of thin film deposition systems have been deployed in the past. However, with typical arrangements of thin film deposition systems, no materials comprising alkali- and/or alkali earth-metals containing dielectric materials have been deposited in the manner described in this application. This is because such multi-element dielectric materials need significantly higher temperatures for evaporation and the basic materials, such as lithium, are highly reactive and form compounds with glass and water. Even though lithium containing dielectrics might be less reactive at room temperatures, they can decompose during evaporation and reactive byproducts can again be generated. As such, there is a desire to provide for arrangements where the internal components of the deposition system stable against these reactive species.

LCO can be of interest as an electrode material of an energy-dense thin film battery; LiPON can be of interest as an electrolyte because of its high ion conductivity. Accordingly, lithium-containing materials are of particular interest since it is suitable for the production of slowly discharging batteries and accumulators.

Common deposition systems for dielectrics, lithium containing dielectrics, and dielectrics of other alkali metals or alkali earth metals, respectively, utilize sputtering sources or conventional point-source based evaporation sources and methods of operating thereof. Evaporation methods for materials containing lithium are challenging, particularly with respect to costs and manufacturability, in light of the high temperatures of Li-containing dielectrics and/or the reactivity of Li. However, the sputtering of sintered targets will be limited by the thermal stability of the target system. This can lead to an upper limit of power density for stable sputtering operation and, thus, to a limited deposition rate.

Conventional evaporation methods for multi-component dielectrics, for example lithium-containing dielectrics, suffer from the requirement of very high temperatures of such materials when provided in the vapor phase. Further, systems which could typically utilize point sources are challenging because of complications in achieving necessary uniformity and manufacturability in scaling it up to high volume manufacturing. Thereby, the need to manage the material supply to the evaporation source is challenging. However, this is necessary for high volume manufacturing and high uptime manufacturing.

### SUMMARY OF THE INVENTION

In light of the above, a deposition arrangement, a deposition apparatus and a method of evaporating according to the claims and particularly the independent claims are provided. Further aspects, advantages, and features of the present invention are apparent from the dependent claims, the description, and the accompanying drawings.

According to one embodiment, a depositing arrangement for evaporation of a dielectric material is provided. The deposition arrangement includes a vapor distribution wherein the vapor distribution showerhead is at least one of a linear vapor distribution showerhead and an elongated tube or cuboid, a holder for providing the dielectric material in the vapor distribution showerhead, wherein the holder has a feeding unit for feeding the dielectric material into the vapor distribution showerhead, an energy source configured for melting and evaporating the dielectric material in the vapor distribution showerhead or sublimating the dielectric material in the vapor distribution showerhead, wherein the vapor distribution showerhead has one or more outlets for directing the vaporized dielectric material towards a substrate, and particularly wherein the energy source emits electrons or photons, wherein the electrons or photons melt and evaporate the dielectric material or sublimate the dielectric material. The arrangement further includes a plasma source configured for providing a plasma between the vapor distribution showerhead and the substrate.

According to another embodiment, a deposition apparatus for evaporation of a dielectric material for deposition of a dielectric material on a substrate is provided. The apparatus includes a vacuum chamber for depositing the material on the substrate, a substrate support provided in the chamber, and a depositing arrangement. The deposition arrangement includes a vapor distribution showerhead, wherein the vapor distribution showerhead is at least one of a linear vapor distribution showerhead and an elongated tube or cuboid, a holder for providing the dielectric material in the vapor distribution showerhead, wherein the holder has a feeding unit for feeding the dielectric material into the vapor distribution showerhead, an energy source configured for melting and evaporating the dielectric material in the vapor distribution showerhead or sublimating the dielectric material in the vapor distribution showerhead, wherein the vapor distribution showerhead has one or more outlets for directing the vaporized dielectric material towards a substrate, and particularly wherein the energy source emits electrons or photons, wherein the electrons or photons melt and evaporate the dielectric material or sublimate the dielectric material. The arrangement further includes a plasma source configured for providing a plasma between the vapor distribution showerhead and the substrate.

According to a further embodiment, a method of evaporating a dielectric material, particularly a lithium-containing dielectric material. The method includes feeding the dielectric material into a vapor distribution wherein the vapor distribution showerhead is at least one of a linear vapor distribution showerhead and an elongated tube or cuboid, liquefying and evaporating the dielectric material in the vapor distribution showerhead or sublimating the material in the vapor distribution showerhead, particularly wherein the liquefying and evaporating or the sublimating comprises the impingement of electrons or photons onto the dielectric material. The method further includes directing the vapor of the dielectric material towards a substrate.

### BRIEF DESCRIPTION OF THE DRAWINGS

So that the manner in which the above recited features of the present invention can be understood in detail, a more particular description of the invention, briefly summarized above, may be had by reference to embodiments. The accompanying drawings relate to embodiments of the invention and are described in the following:
FIG. 1 depicts a schematic cross-sectional view of a processing chamber illustrating an embodiment of the invention.
FIG. 2 depicts a schematic cross-sectional view of another processing chamber illustrating another embodiment of the invention.
FIG. 3 depicts a schematic cross-sectional view of yet another processing chamber used to describe yet further embodiments of the invention.
FIG. 4 depicts a schematic cross-sectional view of a further processing chamber illustrating yet further embodiments of the invention.
FIG. 5 depicts a schematic view of the faces of two linear showerheads in a processing chamber according to one embodiment of the invention.
FIG. 6 depicts a schematic view of the faces of two linear showerheads in a processing chamber according to one embodiment of the invention.
FIG. 7 depicts a schematic cross-sectional view of yet another processing chamber used to describe yet further embodiments of the invention.
FIG. 8 depicts a schematic cross-sectional view of yet another processing chamber used to describe yet further embodiments of the invention.
FIG. 9 is a schematic diagram of an operational sequence for processing a substrate according to one embodiment of the present invention.

### DETAILED DESCRIPTION OF EMBODIMENTS

Reference will now be made in detail to the various embodiments of the invention, one or more examples of which are illustrated in the figures. Within the following description of the drawings, the same reference numbers refer to same components. Generally, only the differences with respect to individual embodiments are described. Each example is provided by way of explanation of the invention and is not meant as a limitation of the invention. Further, features illustrated or described as part of one embodiment can be used on or in conjunction with other embodiments to yield yet a further embodiment. It is intended that the description includes such modifications and variations.

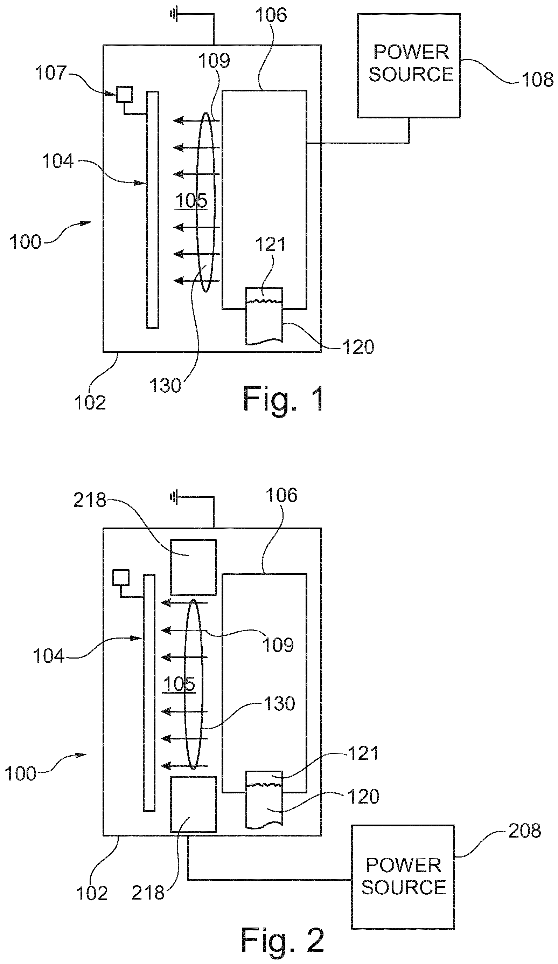

The following discussion of FIGS. 1-9 shows various processing chambers and methods of evaporation dielectric materials and/or ceramics, such as lithium-containing dielectric materials. In particular, the chambers and processing methods relating to dielectric materials and/or ceramics, such as lithium containing dielectrics, are beneficial to perform layer deposition for electrochemical devices, such as the electrochromic windows/devices and solid state thin film batteries. Particularly, large area coaters, and more particularly those with continuous feeding, can be provided by embodiments described herein.

According to embodiments described herein, the apparatuses and methods can be particularly beneficial for evaporation of dielectric materials and/or ceramics, where a dielectric material and/or ceramic is directly provided in the showerhead and melted and evaporated in the showerhead as described in more detail below. Thereby, problems occurring for the typically high evaporation temperatures of dielectric materials and/or ceramics can be resolved. Yet, it is also possible that raw material to be fed into the apparatus, and which is evaporated in the showerhead, further reacts with processing gases in reactive processes to provide different type material layers. Thereby, the raw material can be an initial dielectric material and/or ceramic. Yet, it is also possible that the initial material is an element or another non-dielectric compound. The apparatuses and methods are particularly useful for elements and compounds with high evaporation temperatures, as the number of downstream conduits is reduced as described in more detail below. According to embodiments described herein, which can be combined with other embodiments described herein, a dielectric material is evaporated or sublimated as described herein and a dielectric material is deposited in a substrate. Thereby, the dielectric material that is deposited can be the same dielectric material as the material that is evaporated or sublimated. Alternatively, the dielectric material that this evaporated or sublimated can be subject to a reactive process, e.g. in the plasma, such that another dielectric material is deposited. However, yet further the evaporation or sublimation within a vapor distribution showerhead by impingement of photons or electrons can also be provided for non-dielectric materials or elements, such that a desired material is deposited with or without a respective reactive process in the plasma. These alternatives can be combined with embodiments of arrangements, apparatuses and methods as described herein.

FIGS. 1 and 2 illustrate schematic cross-sectional views of processing chambers according to embodiments. In FIG. 1, an apparatus, such as a processing chamber body 100, for processing a substrate 104 in, for example, a continuous inline production process for electrochemical devices such as solid state thin film batteries and electrochromic window devices is illustrated. The processing chamber includes a chamber wall 102. A processing region 105 is provided in the chamber between a substrate 104 and a distribution showerhead 106, such as a linear showerhead 106 shown in FIG. 1.

A substrate positioner 107 allows to move or position the substrate in and through the procession region 105. In one embodiment of the invention, the processing chamber processes substrates vertically, i.e. the linear distribution showerhead 106 is arranged vertically within the chamber, and the substrate positioner 107 holds a substrate 104 in a vertical processing position as shown in FIG. 1. This arrangement can be considered beneficial as any particles created during processing will fall towards the bottom of the chamber and not contaminate the substrate 104. According to typical embodiments, the substrate positioner can be a magnetic rail system for transporting substrates or carriers with one or more substrates disposed in the carrier through one or more chambers of a substrate processing system. Accordingly, according to some embodiments, an inline processing system and inline processing methods are provided, wherein the substrate is moved past a processing unit, e.g. an evaporation arrangement according to embodiments described herein.

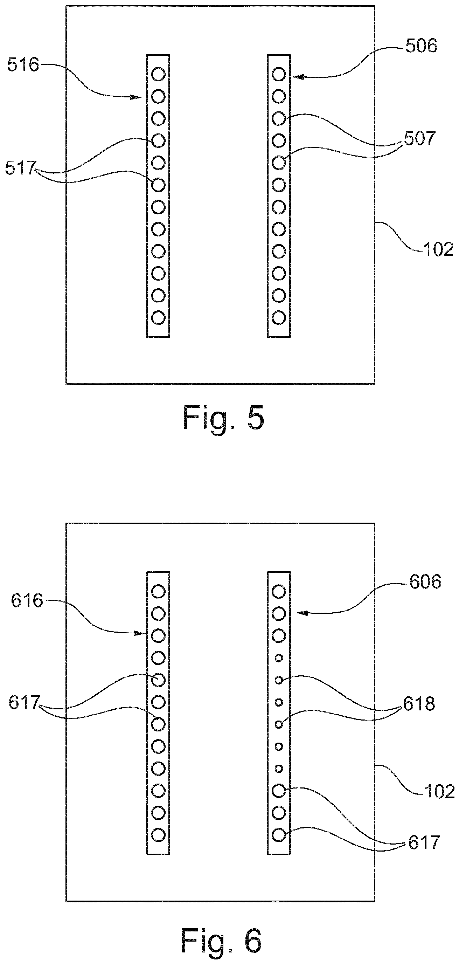

According to some embodiments, and as illustrated in FIG. 1, the linear distribution showerhead 106 disposed in the processing chamber body 100 is electrically coupled to a power source 108. Material to be evaporated is fed into the showerhead and is melted and evaporated in the showerhead, as indicated by region 121. According to embodiments described herein, material to be evaporated is melted and evaporated (or sublimated) in the vapor distribution showerhead and fed to the substrate through one or more respective vapor nozzles. The showerhead, such as a linear vapor distribution showerhead may further comprise passages to modulate the evaporated vapor flux in the processing region 105, examples of which are shown in FIGS. 5 and 6. Such passages can be of varying diameter size and distribution.

The power source 108 may be a direct current (DC), alternating current (AC), pulsed direct current (p-DC), radio frequency (RF), electron cyclotron resonance (ECR), or a microwave or combination thereof power source. Electromagnetic power is provided to the linear showerhead 106 as processing gas, i.e. vapor, is generated in the showerhead 106 and passes into the processing region 105 and towards substrate 104. This is depicted by arrows 109. Whatever type of power source is chosen, the chamber needs to be adapted so that the power source couples energy to the plasma source in such a manner that a plasma 130 will be generated. For example, the showerhead 106 and the substrate (or another counter-electrode) can be connected to the power source 108 and the chamber body 100 can be grounded. According to some embodiments, which can be combined with other embodiments described herein, the substrate or a respective carrier can be biased in addition to a connection of the power supply 108 to the plasma source. Thereby, biasing of the substrate can be utilized for additional enhancement of the plasma enhanced deposition characteristics. For example, this can additionally be provided if a plasma source 218 as shown in FIG. 2 is provided in the deposition apparatus.

An alternative or even additional implementation for generation of plasma 130 is illustrated in FIG. 2. Therein, a plasma source 218, such as a plasma gun, is provided in the chamber body 100. Typically, the plasma gun can be provided adjacent and/or around the processing region 105, such that the plasma 130 is generated in the processing region. According to typical embodiments, which can be combined with other embodiments described herein, the plasma source can be a DC couple plasma, an inductively coupled plasma, a capacitively coupled plasma, or a combination thereof. Thereby, a plasma can e.g. be generated as direct current discharge, pulsed direct current discharge, RF discharge, i.e. in the MHz range, or microwave discharge, i.e. in the GHz range.

According to embodiments described herein, a deposition source and a system for generation of uniform thin-films of Li-containing multi-element dielectric materials at high deposition rates and reduced manufacturing costs are provided. According to typical embodiments, which can be combined with other embodiments described herein, the deposition sources according to embodiments described herein, the systems according to embodiments described herein, and methods according to embodiments described herein, can be applied in any field that require uniform deposition of Li-containing multi-element dielectric materials. For example, such material can be Lithium Cobalt Oxide (LCO), or Lithium Phosphorous Oxynitride (LiPON). Corresponding applications can, thus, for example, be electrochemical devices, such as the electrochromic windows/devices and solid state thin film batteries. In both cases, manufacturing costs need to be reduced significantly to induce broad adaption of the technology.

In light of the feeding of the raw materials directly into the showerhead, as for example shown in FIG. 1 to 4 and 7 to 8, embodiments described herein allow the use of raw materials in the showerhead or distribution nozzle. Thereby, as compared to providing a costly target manufacturing process (e.g. for sputtering), the material costs of the overall device fabrication cost will be reduced by a significant factor. A portion of the cost savings results from the improved materials utilization as compared to targets, wherein the material utilization ranges from ∼ 20 % to 75% while material utilization for evaporation should be 100%, due to melting and evaporation only. Further cost savings result from higher deposition rates for evaporators and the evaporation methods. Accordingly, the throughput and capacity of a given system with the source technology according to embodiments described herein will lead to higher efficiency of capital investment and to lower overall cost (cost of ownership, CoO). Evaporation results in higher deposition rates because there is no upper limit of power density as compared to stable sputtering operation.

According to embodiments described herein, a showerhead-based deposition system and one or more arrangements for plasma enhancement are provided. Thereby, the plasma formation can be used to induce correct phase formation of the material to be deposited on the substrate. Further, a plasma and/or biasing of the substrate, particularly for LCO and LiPON, can result in providing the energy necessary to induce surface mobility of the atoms for densification, smooth morphology and crystallinity (for LCO), which are beneficial for the fabricating of the electrochemical layers and devices of desired performance and yield. Yet further, according to embodiments described herein, a vapor source is provided, which is beneficial for high temperatures, e.g. 1100°C, 1300°C or even above, and which can provide for high throughput manufacturing.

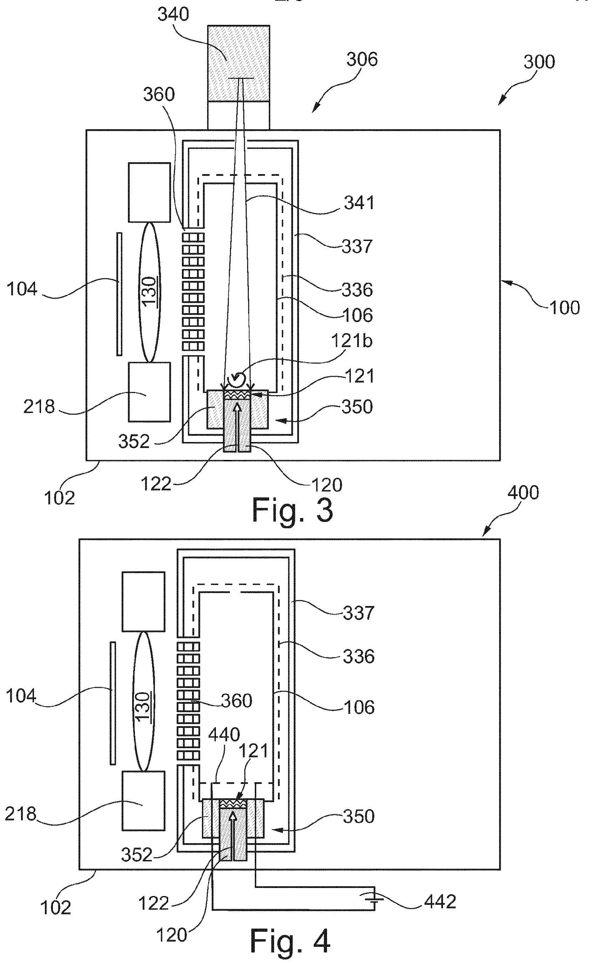

As shown in FIG. 3, a deposition apparatus 300 is provided. The apparatus has a processing chamber body 100, for processing a substrate 104 in, for example, a continuous inline production process for electrochemical devices such as solid state thin film batteries and electrochromic window devices, as illustrated. The processing chamber includes a chamber wall 102. A processing region is provided in the chamber between a substrate 104 and a distribution showerhead 106, such as a linear showerhead 106 shown in FIG. 3.

The deposition system includes an evaporation arrangement 306. The evaporation arrangement 306 includes the showerhead 106. The showerhead can, for example, be provided within a heat insulation 337, such that the vapor distribution showerhead can be more easily and uniformly heated. The showerhead is heated by heater 336, for example a radiation heater. Raw material 120 is provided into the showerhead as indicated by arrow 122. Thereby, the raw material is fed into the showerhead as solid material, as described in more detail below. The raw material is provided in a holder, such as a crucible 350. The crucible has cooling element 352 to cool to crucible.

According to some embodiments, which can be combined with other embodiments described herein, the holder can be a cooled crucible such as a cooled hollow cylinder. In the case of a hollow cylinder being provided as the holder, the raw materials can be fed, pushed, and/or slit through the hollow cylinder 352 with a feeding unit. Thereby, a continuous or quasi-continuous supply of raw material can be provided.

A material feed unit, which is provided for embodiments described herein unit is illustrated by arrow 122. The material feed unit can be an actuator, a pressure cylinder or any other element configured to push or slide the material in the vapor distribution showerhead.

According to yet further embodiments, which can be combined with other embodiments described herein, the cooling of the crucible can be provided by cooling channels in the holder through which a fluid can flow. The fluid can be a gas or a liquid, e.g. water. Yet further, the cooling unit can also be provided by other ways of cooling, as known in the art.

In the embodiment shown in FIG. 3, the raw material is melted and evaporated by e-beam based heating. It is to be understood that arrangements, apparatuses and methods for materials, which are sublimated instead of first melted and evaporated thereafter, are also included in embodiments described herein. Electron gun 340 directs electron beam 341 onto the material in the crucible 350. Thereby, the material is melted as indicated by reference numeral 121 denoting a melting area in the crucible, and the material is evaporated as indicated by reference numeral 121b denoting a vapor area. The vapor is distributed within the vapor distributor and directed through nozzles 360 towards the substrate. According to some embodiments, the vapor of the material to be deposited passes through a plasma 130 in the processing area before being deposited on the substrate 104.

Accordingly, according to some embodiments, which can be combined with other embodiments described herein, an e-beam based heating can be provided. Thereby, faster and higher temperature capability and control is induced. Further, "down-stream" conduits from an evaporating reservoir to the showerhead in the chamber are eliminated.

As shown in FIG. 4, an alternative or additional element and method for heating a thermal heating element 440 or thermal heating methods can be provided. Thereby, the heating element can be resistive thermal or radiative thermal. The heating element 440 is connected to power supply 442 to provide thermal energy to the material in the crucible 350. According to typical embodiments, radiation heating is provided, wherein photons impinge on the material to be melted and evaporated (or sublimate). Accordingly, the heating element or heat source and the reservoir for the material to be deposited can be separated. By separating the heating source and the reservoir, the source management and maintenance can be easier. This is because replacement of the reservoir or replacement of the heating unit is a smaller replacement as compared to combined reservoir-heating-unit-replacement. Other elements shown in FIG. 4 correspond to other embodiments described herein with respect to FIGS. 1 to 3 and 5-8, particularly FIG. 3, and are omitted here to avoid repetition.

As shown in FIG. 3 and according to some embodiments described herein, the e-beam evaporation source with the electron gun 340 provides the evaporation area 121b such that the evaporation area 121b and the showerhead 106 are a part of or within the same enclosure. Accordingly, any need to "carry" the evaporant or vapor to the showerhead with heated downstream conduits is eliminated. For a remote vapor generation, heating of the conduits would be provided to avoid condensation of the evaporant or vapor along its path to the deposition zone. As shown in FIG. 4, the radiation heater or method of heating the precursors by a radiative thermal method also provides a simpler evaporation source, e.g. a linear evaporation source. Again the evaporation area 121b and the showerhead 106 are a part of or within the same enclosure. Thereby, also heated downstream conduits are eliminated.

According to embodiments described herein, a heating unit as described with respect to FIGS. 3 and 4 can be provided. The heating unit can comprise at least one element of the group consisting of: a radiation heater for heating the material to be evaporated, an electron beam gun for heating the material to be evaporated, and a heater for heating of the vapor distribution showerhead. The heating unit for heating the material to be evaporated, i.e. for melting and evaporating the raw material, thereby emits photons, e.g. in the case of a radiation heater, or electrons, e.g. in the case of an electron gun. The photons or electrons heat the material upon impingement of the photons or electrons. According to yet further embodiments, the heat generation for melting and evaporation (or sublimation) in the showerhead can also be provided by an electrical heater or another heating element. For example, the crucible can be heated by a current flowing through the crucible or by a current flowing through electrical heater windings provided at or in the crucible.

In light of the fact that there are little or no limitations of evaporation energy to be inserted (as compared to e.g. sputter deposition) embodiments described herein allow for higher deposition rates. Thereby, it is also to be considered that the source feeding system allows for continuous or quasi-continuous feeding of raw material for a highly controlled hardware configuration of the components of the evaporation zone. Thereby, good control of the heating mechanisms and of the evaporation zone, i.e. the top layer of the source of raw material or the area directly above the top layer of the source can be provided..

Yet further, according to embodiments described herein, plasma enhancement is provided to allow for improved deposition of some multi-element dielectric materials and/or ceramics which can dissociate into simpler compounds upon heating and evaporation. Thereby, also modulation of growth kinetics and surface morphology, i.e. control the surface morphology, film density, etc., can be provided as needed. The use of plasma enhancement provides enhancement of deposition phenomena, for example, to provide for smoother and pinhole free deposition, which can be a critical aspect for high quality layers of materials and devices described herein.

Improving growth kinetics modulation for smoother and pinhole free deposition by plasma enhanced deposition leads to cost reduction and better device. Cost reduction can thereby be provided by higher yield due to smooth and/or pinhole free dielectric deposition. For example, smooth LCO will lead to more conformal LiPON for reduced risk of internal short in an electrochemical device. Further, alone deposition of smoother LiPON and deposition of LiPON with less pinhol will lead to a lower risk of internal short. According to another aspect, a cost reduction can be provided from LiPON with less pinholes wherein such layers can be deposited with lower thickness if the amount of pinhole is reduced or pinholes are eliminated. The reduced layer thickness results in a reduced cost of such a layer. Thereby, yet further, a performance enhancement can be provided by a thinner LiPON layer, which leads to lower internal resistance for higher power and charge capability. Yet further, additionally or alternatively, cost reduction as compared to sputtering can be provided by eliminating the target manufacturing costs. It has been demonstrated that PE-EBEAM deposition of LiPON results in good phase formation

According to some embodiments, which can be combined with other embodiments described herein, the evaporation sources and apparatuses described herein can be utilized for evaporation on large area substrates, e.g. displays or for electrochromic windows or lithium battery manufacturing. According to some embodiments, large area substrates or respective carriers, wherein the carriers have one or more substrates, may have a size of at least 0.67 m². Typically, the size can be about 0.67m² (0.73x0.92m - Gen 4.5) to about 8 m², more typically about 2 m² to about 9 m² or even up to 12 m². Typically, the substrates or carriers, for which the structures, apparatuses, such as cathode assemblies, and methods according to embodiments described herein are provided, are large area substrates as described herein. For instance, a large area substrate or carrier can be GEN 4.5, which corresponds to about 0.67 m² substrates (0.73x0.92m), GEN 5, which corresponds to about 1.4 m² substrates (1.1 m x 1.3 m), GEN 7.5, which corresponds to about 4.29 m² substrates (1.95 m x 2.2 m), GEN 8.5, which corresponds to about 5.7m² substrates (2.2 m x 2.5 m), or even GEN 10, which corresponds to about 8.7 m² substrates (2.85 m x 3.05 m). Even larger generations such as GEN 11 and GEN 12 and corresponding substrate areas can similarly be implemented.

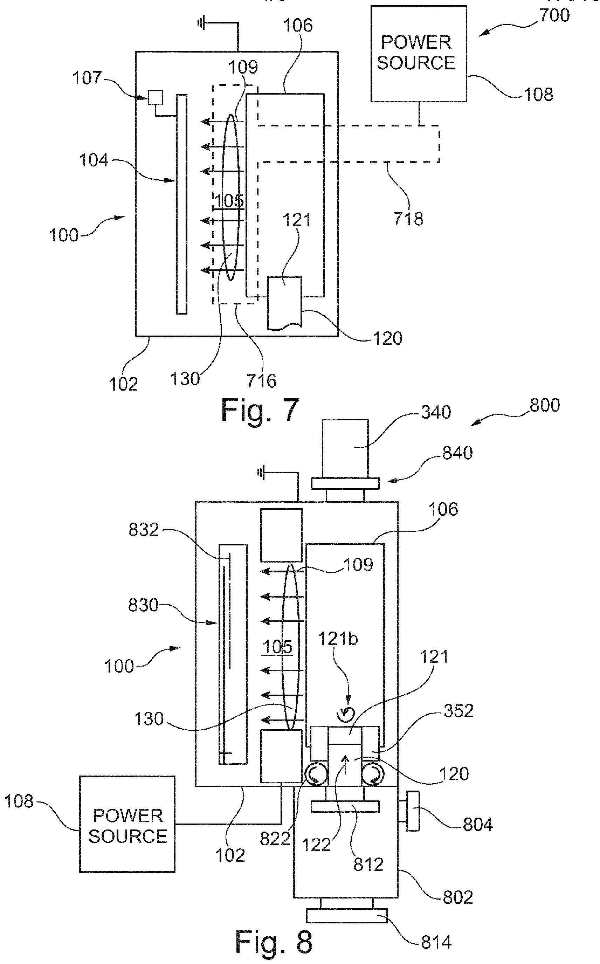

FIGS. 5 and 6 depict a schematic view of the faces of two linear showerheads in a processing chamber according to various embodiments of the invention. FIG. 5 shows the chamber body wall 102 surrounding the linear showerheads 506 and 516 as depicted e.g. in FIGS. 1 to 4. In this embodiment, the linear vapor distribution showerhead 506 and a linear plasma distribution showerhead 516, e.g. for remote plasma generation as described with respect to FIG. 7, each have passageways 507 and 517, respectively, that are the same diameter. In the embodiment shown in FIG. 6, the linear gas distribution showerhead 606 has varying diameter passageways, 617 and 618, for modulating the process vapor flux from the linear vapor distribution showerhead 606 and into the processing region. Other non-circular cross-sectional shapes of passageways may be used where the cross-sectional circumference or perimeter varies in size. For example square cross-sectional passageways may be used having a smaller cross-sectional perimeter compared to other square gas passageways on the same linear gas distribution showerhead. Although a perimeter is generally used in conjunction with non-circular shapes, it may also encompass circular shapes and thus their corresponding circumferences. Other various shapes and sizes of the gas passageway are within the scope of embodiments of the invention, and can be readily identified by those of ordinary skill in the art. Although FIGS. 5 and 6 depict the two showerhead configurations as referred to with respect to FIG. 7, any of the linear gas distribution showerheads 106 may also be used in the processing chamber body 100, according to embodiments described herein.

FIG. 7 shows another embodiment of a deposition apparatus 700. Thereby, several aspects, features and details of embodiments described above with respect to FIG. 1 to 6 can be combined with the aspects, features and details described with respect to FIG. 7. These aspects, features and details are omitted to avoid repetition. FIG. 7 shows another schematic cross sectional view of a processing chamber body 100. Alternatively to, or according to some embodiments additionally to, the plasma generation components shown with respect to other embodiments described herein, FIG. 7 shows a remote plasma source 718. As already described with respect to other figures herein, the apparatus includes a processing chamber body 100 having a chamber wall 102. A processing region 105 is defined by the chamber walls 102, the substrate 104, a linear vapor distribution showerhead 106, and a linear remote plasma distribution showerhead 716.

A substrate positioner 107 helps to move the substrate 104 through the processing region 405 or to position the substrate 104 in the processing region 405. In one embodiment of the invention, the processing chamber processes substrates vertically, i.e. the linear vapor distribution showerhead 106 and a linear remote plasma distribution showerhead 716 are arranged vertically within the chamber and the substrate positioner 107 holds a substrate 104 in a vertical processing position as shown in FIG. 7. The remote plasma source 718 is coupled to the linear remote plasma distribution showerhead 716 and electrically coupled to a power source 108.

As before, the power source 108 may be a direct current (DC), alternating current (AC), pulsed direct current (p-DC), radio frequency (RF), electron cyclotron resonance (ECR), or a microwave or combination thereof power source. Electromagnetic power is provided to the remote plasma source 718 as a processing gas passes through the remote plasma source 718, through the linear remote plasma distribution showerhead 716, into the processing region 105, and towards substrate 104, as depicted by arrows 109. Additionally, in any of the embodiments, the substrate may be electrically biased depending on the chamber configuration, type of power source coupled to the chamber, and the type of source materials and desired film to be deposited on the substrate.

The outlets of the vapor distribution showerhead can be provided according to several implementations, which can be provided independent from each other or partly even in combination if not mutually exclusive. The material to be deposited is directed from the vapor distribution showerhead 106 through one or more respective vapor nozzles. According to some embodiments, which can be combined with other embodiments described herein, the evaporator arrangement can include a nozzle for guiding the vapor towards the substrate. As shown in the figures, the arrangement can include a vapor distribution showerhead 106, e.g. a linear vapor distribution showerhead 106 having a plurality of nozzles 360. By providing a linear vapor distribution showerhead 112 uniformity of the deposition on the substrate 104 can be increased. However, it has to be considered that a plurality of nozzles also results in an increasing demand of continuous and controlled flow of the material towards the vapor distribution showerhead, as well as the need to provide new material into the system. Accordingly, the material feed system of feeding raw material directly into the showerhead via a crucible and the option to continuously feed the material as indicated by arrows 122 can be considered particularly beneficial. Due to such an ability to provide new material, a continuous or quasi-continuous operation of the evaporation arrangement, of an apparatus for evaporation having such an evaporation arrangement according to embodiments described herein, or of a system for evaporation having such an evaporation arrangement according to embodiments described herein, can be provided.

Although the showerhead shown in FIG. 1 is a linear showerhead, other shapes of showerheads are also within the scope of the invention. What shape the showerhead should have will depend on both, the type of chamber and the shape of the substrate. For example, a point source, i.e. a single nozzle, or a circular showerhead may be selected for a chamber that processes circular substrates, such as when processing semiconductor wafers. Whereas a rectangular showerhead may be selected for processing large rectangular substrates, batch processes may also make those types of showerhead shapes more preferable. For continuous inline processing of large size rectangular or square substrates, a linear showerhead may be selected to better control the distribution of process gases over the substrate as the substrate passes by the showerhead. Accordingly, beneficially linear vapor distribution showerheads can be used, particularly for in-line or dynamic processing apparatus. Circular, rectangular or two or more linear vapor distribution showerheads can be used for static deposition processes of substrates of various shape and size.

According to some embodiments, which can be combined with other embodiments described herein, material is provided in the showerhead, e.g. in solid form such as a rod, a powder or in another solid form. An energy source directs photons or electrons on the material, such that vapor of the material is generated in the showerhead by melting and evaporation or by sublimation. Thereby, a showerhead as understood herein, has an enclosure into which the material can be fed, and which has openings in the enclosure such that the pressure in the showerhead is higher than outside of the showerhead, for example at least one order of magnitude. According to typical embodiments, which can be combined with other embodiments described herein, the vapor distribution showerhead can be an elongated tube, such as a circular tube, or an elongated cuboid, e.g. in the case of a square showerhead. The tube or the cuboid forms an enclosure around a hollow volume. For circular showerheads, a disc-shaped cylindrical body having a hollow volume may also be provided. Heating elements can be provided in the respective above-described hollow volume. The enclosure provides the one or more outlets for directing the vapor towards the substrate. The one or more outlets can be nozzles or openings provided at the enclosure.

The outlets, e.g. nozzles 360, provided at the vapor distribution showerhead guide or direct the vapor of the dielectric material, e.g. a lithium-containing dielectric, towards the substrate 104. According to typical embodiments, the outlets or nozzles can also be provided as openings in the vapor distribution showerhead. Further, for a linear vapor distribution showerhead, the arrangement of openings or nozzles can be for example one or more lines of openings or nozzles. For rectangular vapor distribution showerheads, the openings or nozzles can be distributed along and within a rectangular shape. For round vapor distribution showerheads, the openings or nozzles can be distributed along and within a circular shape. Typically, the openings or nozzles can be distributed such that the deposition of the vapor on the substrate 104 is uniform. Thereby, the openings or nozzles can be at least partly uniformly distributed along one of the above described shapes. However, in order to compensate for edge effects at the perimeter of the shape, the density of openings or nozzles can be varied in some regions of the vapor distribution showerhead, as for example described with respect to FIGS. 5 and 6.

As described with respect to FIG. 8, yet further embodiments of a deposition apparatus 800 can be provided. The apparatus has a processing chamber body 100, for processing a substrate 104 in, for example, a continuous inline electrochromic device production process, as illustrated. For example, the electrochemical device can be a solid state thin film battery or an electrochromic window device. The processing chamber includes a chamber wall 102. A processing region is provided in the chamber between a substrate 104 and a distribution showerhead 106, such as a linear showerhead 106 shown in FIG. 3. According to some embodiments, which can be combined with other embodiments described herein, a substrate support 830 having wafers 832 disposed therein can be provided. Thereby, for example apertures such as slit apertures can further be provided for depositing the vapor onto the substrates in predefined areas.

According to yet further embodiments, the height of the processing area 105 can be in a range of 400 to 2000 mm, for example 440 mm. Thereby, the height of the processing area can be determined by the height of the vapor distribution showerhead and/or the number of vapor distribution showerheads or nozzles provided in the chamber body 100.

Also in the embodiment shown in FIG. 8, the raw material is melted and evaporated by e-beam based heating. Electron gun 340 directs electron beam 341 onto the material in the crucible 350. Thereby, the material is melted as indicated by reference numeral 121 denoting a melting area in the crucible, and the material is evaporated as indicated by reference numeral 121b denoting a vapor area. The vapor is distributed within the vapor distributor and directed through nozzles 360 towards the substrate. According to some embodiments, the vapor of the material to be deposited passes through a plasma 130 in the processing area before being deposited on the substrate 104. As described herein, a crucible is a container or holder that can withstand very high temperatures. Further, the crucible can be cooled and the crucible according to embodiments described herein can hold a rod of material disposed in and through the crucible.

Accordingly, according to some embodiments, which can be combined with other embodiments described herein, an e-beam based heating can be provided. Thereby, faster and higher temperature capability and control is induced. Further, "down-stream" conduits from an evaporating reservoir to the showerhead in the chamber are eliminated. Also heating arrangements as for example described with respect to FIG. 8 can be combined with the aspects described with respect to FIG. 3.

As shown in FIG. 8 and according to some embodiments described herein, the e-beam evaporation source with the electron gun 340 provide the evaporation area 121b such that the evaporation area 121b and the showerhead 106 are a part of or within the same enclosure. Accordingly, any need to "carry" the evaporant or vapor to the showerhead with heated downstream conduits is eliminated. Thereby, a remote vapor generation heating of the conduits would be provided to avoid condensation of the evaporant or vapor along its path to the deposition zone.

According to some embodiments, which can be combined with other embodiments described herein, the raw material 120 is provided into the showerhead as indicated by arrow 122. Thereby, the raw material is fed into the showerhead as solid material from the further chamber 802. The raw material is provided in a crucible 350. The crucible has cooling element 352 to cool the crucible. The material to be fed into the chamber and through the cooled crucible can be inserted through a first valve unit 814 in chamber 802. After closing of the valve unit 814, the chamber 802 can be evacuated. Accordingly, the chamber typically has a vacuum flange 804. Upon reducing the pressure in the chamber 802 sufficiently, the valve unit 812 connecting the chamber body 100 and the further chamber 802 can be opened, and the raw material can be fed into the crucible in order to allow for a continuous supply of raw material. Typically, the raw materials can be moved along arrow 122 or within chamber 802 by one or more handling systems or raw material transport systems, which can be provided as desired for the respective apparatus design. An exemplary feed unit is shown by feed unit 822, which can move the material in direction of arrow 122. The feed unit 822 can be provided as rollers moving the material and/or the crucible (not shown) or as a wheel being in mechanical contact with a thread in the crucible for advancing the crucible in direction of arrow 122. Optionally, a gear can be provided in order to better provide for the relatively small movements of the material. Another example of a feed unit can be an actuator, which moves a subsequent rod of raw material upward in chamber 802 and thereby slides or pushes the material 120 upward in chamber body 100.

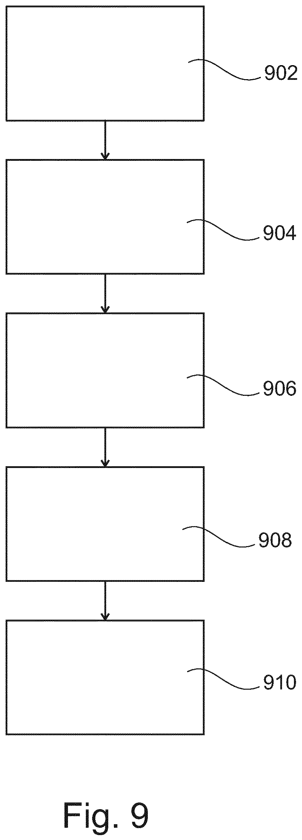

Embodiments of operating deposition arrangements for evaporation of Li-containing dielectrics and corresponding deposition apparatuses are now described with respect to FIG. 9. In step 902 the material to be evaporated is guided in a vapor distribution showerhead, for example, by or through a crucible. The material to be evaporated is melted and vaporized in the vapor distribution showerhead in step 904. This is, for example, done by impingement of particles, e.g. electrons, or photons. For example, radiation heating with thermal radiation or electron-beam heating can be provided to melt the material in the vapor distribution showerhead. In step 906, the vapor is directed through one or more outlets of the vapor distribution showerhead towards the substrate. A plasma is ignited such that a plasma region can be provided between the outlets of the vapor distribution showerhead and the substrate as indicated by step 908. Thereby, a plasma enhancement of the vapor deposition can be provided. Optionally, it is further possible to provide processing gases such as reactive processing gases in the plasma region to further allow for the vapor to react with the processing gas before or while being deposited on the substrate. This is illustrated by optional step 910. Yet, further optionally, as described above, the substrate or a respective carrier can be biased in addition to a plasma generation. Thereby, biasing of the substrate can be utilized for additional enhancement of the plasma enhanced deposition characteristics.

According to some embodiments, which can be combined with other embodiments described herein, the lithium-containing dielectric film can be deposited by evaporating Li₃P0₄. A composition of a reactive processing gas mixture, e.g, a nitrogen-containing plasma, can then result in the formation of LiPON due to reaction of the vapor exiting the showerhead with nitrogen of the processing gas. Further, according to some embodiments, which can be combined with other embodiments described herein, the vapor generated in the showerhead and exiting the showerhead can be an element such as silicon. The silicon can react with oxygen and/or nitrogen to provide a dielectric layer for deposition on the substrate.

Accordingly, due to plasma enhancement, embodiments of the invention may also provide improved control of surface morphology of the depositing film layers to minimize and possibly eliminate pinholes and create smooth surfaces. Additionally, embodiments of the invention improve induction of forming reacted phases with existing layers or with additional co-depositing species. Moreover, these improvements can be achieved at lower processing temperatures. For example, LiCo0₂ or Li₃PO₄ would dissociate when evaporated with plasma enhancement, and thus plasma enhancement is beneficial for correct phase formation. Other materials, e.g. SiO₂, Si₃N₄, Al₂O₃, etc., can have benefits over plasma enhancement in other ways, like crystallinity, morphology, and/or density of the deposited layer. Yet, such benefits are also true for the LiCoO₂ and Li₃PO₄.

Beyond the above described benefits, which can partly or fully be provided depending on the utilization of individual embodiments, manufacturability improvement will result from the ease of handling. For example, powders or smaller raw material pieces can be provided in the showerhead. This is compared to providing very large targets for sputtering. The material feeding, according to embodiments described herein, further provides the potential for continuous feeding without a chamber vent, or with reduced preventive maintenance requirements.

While the foregoing is directed to embodiments of the invention, other and further embodiments of the invention may be devised without departing from the basic scope thereof, and the scope thereof is determined by the claims that follow.

## Claims

1. A depositing arrangement (306) for evaporation of a dielectric material, particularly a lithium-containing dielectric material, comprising:
a vapor distribution showerhead (106, 506, 606) wherein the vapor distribution showerhead is at least one of a linear vapor distribution showerhead and an elongated tube or cuboid;
a holder (350) for providing the dielectric material in the vapor distribution showerhead, wherein the holder has a feeding unit for feeding the dielectric material into the vapor distribution showerhead;
an energy source (108, 336) configured for melting and evaporating the dielectric material in the vapor distribution showerhead or sublimating the dielectric material in the vapor distribution showerhead, wherein the vapor distribution showerhead has outlets (507, 517, 617, 618) for directing the vaporized dielectric material towards a substrate (104), and particularly wherein the energy source emits electrons or photons, wherein the electrons or photons melt and evaporate the dielectric material or sublimate the dielectric material; and
a plasma source (218, 718) configured for providing a plasma between the vapor distribution showerhead and the substrate.

2. The arrangement (306) according to claim 1, wherein the holder is a crucible having cooling elements (352) for cooling the crucible.

3. The arrangement (306) according to claim 1 or 2, wherein the plasma source is provided by biasing the vapor distribution showerhead and a counter electrode, particularly wherein the substrate support (830) is provided as the counter electrode.

4. The arrangement (306) according to any of claims 1 to 3, wherein the plasma source is provided in a processing region (105) disposed between the vapor distribution showerhead and the substrate.

5. The arrangement (306) according to any of claims 1 to 4, wherein the plasma source is a remote plasma source.

6. The arrangement (306) according to any of claims 1 to 5, wherein the dielectric material is Li₃PO₄ or LCO.

7. A deposition apparatus (800) for evaporation of a dielectric material and for deposition of a dielectric material on a substrate, the apparatus comprising:
a vacuum chamber (100) for depositing the dielectric material on the substrate;
a substrate support (830) provided in the chamber, and
a depositing arrangement (306) according to any of claims 1 to 6.

8. The apparatus (800) according to claim 7, further comprising:
a substrate support system disposed in the vacuum chamber, wherein the substrate support system is configured for vertical support of the substrate or a carrier carrying the substrate in the vacuum chamber.

9. A method of evaporating a dielectric material, particularly a lithium-containing dielectric material, comprising:
feeding (902) the dielectric material into a vapor distribution showerhead, wherein the vapor distribution showerhead is at least one of a linear vapor distribution showerhead and an elongated tube or cuboid;
liquefying and evaporating (904) the dielectric material in the vapor distribution showerhead or sublimating the material in the vapor distribution showerhead, particularly wherein the liquefying and evaporating or the sublimating comprises the impingement of electrons or photons onto the dielectric material; and
directing (906) the vapor of the dielectric material towards a substrate.

10. The method according to claim 9, wherein the vapor distribution showerhead is heated to a temperature of 1100°C to 1500°C, particularly about 1300°C.

11. The method according to claim 9 or 10, wherein the dielectric material is Li₃PO₄ or LCO.

12. The method according to any of claims 9 to 11, further comprising:
providing a plasma between the vapor distribution showerhead and the substrate.

13. The method according to any of claims 9 to 12, wherein the impingement of electrons is provided by an electron gun.

## Patentansprüche

1. Abscheidungsanordnung (306) zur Verdampfung eines dielektrischen Materials, insbesondere eines Lithium enthaltenden dielektrischen Materials, umfassend:
einen Dampfverteilungskopf (106, 506, 606), wobei der Dampfverteilungskopf ein linearer Dampfverteilungskopf und/oder ein längliches Rohr oder Quader ist;
ein Halter (350) zum Bereitstellen des dielektrischen Materials in dem Dampfverteilungskopf, wobei der Halter eine Zufuhreinheit zum Zuführen des dielektrischen Materials in den Dampfverteilungskopf hat;
eine Energiequelle (108, 336), die zum Schmelzen und Verdampfen des dielektrischen Materials in dem Dampfverteilungskopf oder zum Sublimieren des dielektrischen Materials in dem Dampfverteilungskopf ausgelegt ist, wobei der Dampfverteilungskopf Auslässe (507, 517, 617, 618) hat, um das verdampfte dielektrische Material zu einem Substrat (104) hin zu lenken, und insbesondere wobei die Energiequelle Elektronen oder Photonen ausstrahlt, wobei die Elektronen oder Photonen das dielektrische Material schmelzen und verdampfen oder das dielektrische Material sublimieren; und
eine Plasmaquelle (218, 718), die zum Bereitstellen eines Plasmas zwischen dem Dampfverteilungskopf und dem Substrat ausgelegt ist.

2. Anordnung (306) nach Anspruch 1, wobei der Halter ein Tiegel mit Kühlelementen (352) zum Kühlen des Tiegels ist.

3. Anordnung (306) nach Anspruch 1 oder 2, wobei die Plasmaquelle durch Vorspannen des Dampfverteilungskopfes und einer Gegenelektrode bereitgestellt wird, wobei insbesondere der Substratträger (830) als die Gegenelektrode bereitgestellt wird.

4. Anordnung (306) nach einem der Ansprüche 1 bis 3, wobei die Plasmaquelle in einem Verarbeitungsbereich (105), der zwischen dem Dampfverteilungskopf und dem Substrat angeordnet ist, bereitgestellt wird.

5. Anordnung (306) nach einem der Ansprüche 1 bis 4, wobei die Plasmaquelle eine Remote-Plasmaquelle ist.

6. Anordnung (306) nach einem der Ansprüche 1 bis 5, wobei das dielektrische Material Li₃PO₄ oder LCO ist.

7. Abscheidungseinrichtung (800) zur Verdampfung eines dielektrischen Materials und zur Abscheidung eines dielektrischen Materials auf einem Substrat, die Einrichtung umfassend:
eine Vakuumkammer (100) zum Abscheiden des dielektrischen Materials auf dem Substrat;
einen Substratträger (830), der in der Kammer bereitgestellt ist, und
eine Abscheidungsanordnung (306) nach einem der Ansprüche 1 bis 6.

8. Einrichtung (800) nach Anspruch 7, ferner umfassend:
ein Substratträgersystem, das in der Vakuumkammer angeordnet ist, wobei das Substratträgersystem zum vertikalen Tragen des Substrats oder eines Trägers, der das Substrat trägt, in der Vakuumkammer ausgelegt ist.

9. Verfahren zum Verdampfen eines dielektrischen Materials, insbesondere eines Lithium enthaltenden dielektrischen Materials, umfassend:
Zuführen (902) des dielektrischen Materials in einen Dampfverteilungskopf, wobei der Dampfverteilungskopf ein linearer Dampfverteilungskopf und/oder ein längliches Rohr oder Quader ist;
Verflüssigen und Verdampfen (904) des dielektrischen Materials in dem Dampfverteilungskopf oder Sublimieren des Materials in dem Dampfverteilungskopf, wobei insbesondere das Verflüssigen und Verdampfen oder das Sublimieren das Auftreffen der Elektronen oder Photonen auf dem dielektrischen Material umfasst; und
Lenken (906) des Dampfes des dielektrischen Materials zu einem Substrat hin.

10. Verfahren nach Anspruch 9, wobei der Dampfverteilungskopf auf eine Temperatur von 1100 °C bis 1500 °C, insbesondere etwa 1300 °C, erhitzt wird.

11. Verfahren nach Anspruch 9 oder 10, wobei das dielektrische Material Li₃PO₄ oder LCO ist.

12. Verfahren nach einem der Ansprüche 9 bis 11, ferner umfassend:
Bereitstellen eines Plasmas zwischen dem Dampfverteilungskopf und dem Substrat.

13. Verfahren nach einem der Ansprüche 9 bis 12, wobei das Auftreffen der Elektronen durch eine Elektronenquelle bereitgestellt wird.

## Revendications

1. Agencement de dépôt (306) pour l'évaporation de matériau diélectrique, particulièrement de matériau diélectrique contenant du lithium, comprenant :
une pomme distributrice de vapeur (106, 506, 606), la pomme distributrice de vapeur étant au moins l'une parmi une pomme distributrice de vapeur linéaire et un tube allongé ou un cuboïde ;
un support (350) pour apporter le matériau diélectrique dans la pomme distributrice de vapeur, le support comportant une unité d'alimentation pour apporter le matériau diélectrique dans la pomme distributrice de vapeur ;
une source d'énergie (108, 336) conçue pour faire fondre et évaporer le matériau diélectrique dans la pomme distributrice de vapeur ou pour sublimer le matériau diélectrique dans la pomme distributrice de vapeur, la pomme distributrice de vapeur comportant des sorties (507, 517, 617, 618) pour diriger le matériau diélectrique vaporisé vers un substrat (104), et, particulièrement, la source d'énergie émettant des électrons ou des photons, les électrons ou les photons faisant fondre et évaporer le matériau diélectrique ou sublimer le matériau diélectrique ; et
une source de plasma (218, 718) conçue pour apporter un plasma entre la pomme distributrice de vapeur et le substrat.

2. Agencement (306) selon la revendication 1, dans lequel le support est un creuset doté d'éléments de refroidissement (352) pour refroidir le creuset.

3. Agencement (306) selon la revendication 1 ou 2, dans lequel la source de plasma est apportée en inclinant la pomme distributrice de vapeur et une contre-électrode, le support de substrat (830) étant en particulier prévu pour faire office de contre-électrode.

4. Agencement (306) selon l'une quelconque des revendications 1 à 3, dans lequel la source de plasma est prévue dans une zone de traitement (105) disposée entre la pomme distributrice de vapeur et le substrat.

5. Agencement (306) selon l'une quelconque des revendications 1 à 4, dans lequel la source de plasma est une source de plasma distante.

6. Agencement (306) selon l'une quelconque des revendications 1 à 5, dans lequel le matériau diélectrique est du Li₃PO₄ ou du LCO.

7. Appareil de dépôt (800) pour l'évaporation d'un matériau diélectrique et pour le dépôt d'un matériau diélectrique sur un substrat, cet appareil comprenant :
une chambre à vide (100) pour déposer le matériau diélectrique sur le substrat ;
un support de substrat (830) prévu dans la chambre, et
un agencement de dépôt (306) selon l'une quelconque des revendications 1 à 6.

8. Appareil (800) selon la revendication 7, comprenant en outre :
un système de support de substrat disposé dans la chambre à vide, le système de support de substrat étant conçu pour supporter verticalement le substrat ou un système porteur supportant le substrat dans la chambre à vide.

9. Procédé d'évaporation d'un matériau diélectrique, en particulier d'un matériau diélectrique contenant du lithium, comprenant :
l'incorporation (902) du matériau diélectrique dans une pomme distributrice de vapeur, la pomme distributrice de vapeur étant au moins l'une parmi une pomme distributrice de vapeur linéaire et un tube allongé ou un cuboïde ;
la liquéfaction et l'évaporation (904) du matériau diélectrique dans la pomme distributrice de vapeur ou la sublimation du matériau dans la pomme distributrice de vapeur, la liquéfaction et l'évaporation ou la sublimation comprenant en particulier l'envoi d'électrons ou de photons sur le matériau diélectrique ; et
l'orientation (906) de la vapeur du matériau diélectrique vers un substrat.

10. Procédé selon la revendication 9, dans lequel la pomme distributrice de vapeur est chauffée à une température de 1100 °C à 1500 °C, particulièrement à environ 1300 °C.

11. Procédé selon la revendication 9 ou 10, dans lequel le matériau diélectrique est du Li₃PO₄ ou du LCO.

12. Procédé selon l'une quelconque des revendications 9 à 11, comprenant en outre :
l'apport d'un plasma entre la pomme distributrice de vapeur et le substrat.

13. Procédé selon l'une quelconque des revendications 9 à 12, dans lequel l'envoi d'électrons est réalisé par une source à électrons.
